# EUROPEAN PATENT APPLICATION

(11) **EP 1 160 843 A1**
(43) Date of publication of application: **05.12.2001**
(21) Application number: 00111576.5
(22) Date of filing: 30.05.2000
(51) Int. Cl.: H01L 21/027, G03F 7/09

(54) **Planarizing anti-reflective coating layer with improved light absorption**

(71) Applicant: Semiconductor 300 GmbH & Co. KG, 01099 Dresden (DE)
(72) Inventor: Zimmermann, Jens, 01465 Langebrueck (DE)
(74) Representative: Fischer, Volker, Dipl.-Ing.

(57) **Abstract**

Instead of a single anti-reflective coating layer of medium viscosity employed according to prior art, the present invention discloses providing two anti-reflective coating layers one after the other. The first layer (ARC1) consists of a material of low viscosity and the second layer (ARC2) consists of a material of high viscosity or vice versa, thereby allowing for conformal deposition all over the surface of a semiconductor product as well as for improved planarizing performance at the same time.

## Description

### Description of the Invention

The present invention relates to a semiconductor product comprising a layer with a surface of high topography, up-areas as well as down-areas being provided on the surface and a first anti-reflective coating layer coating the layer. The invention further relates to a method for manufacturing a semiconductor product comprising the steps of providing a semiconductor wafer having a layer with a surface of high topography, up-areas as well as down-areas being provided on the surface, and of coating the layer with a first anti-reflective coating layer.

In the manufacture of semiconductor products several layers are deposited onto the semiconductor product in sequence.

Each layer has to be patterned before depositing a next layer in order to shape the microelectronic elements and their connections onto the semiconductor product surface. For patterning, a mask layer is deposited onto the layer to be patterned and lithographic techniques are applied in order to first pattern the mask layer itself. After etching the exposed mask layer and controlling the dimensions of the patterned mask layer, the layer beneath the mask layer is patterned, for instance by etching or doping process steps.

Due to the shrinking dimensions of current microelectronic elements even beyond the wavelength of the UV-radiation employed for exposing the mask, interference effects occur within the mask layer. Multiple reflections at the upper and the lower surface of the mask layer cause standing waves perpendicular to the semiconductor wafer plane. Though the variations of light absorption as a function of the height of the mask layer are compensated by a post-exposure bake step, the average light exposure still depends on whether the local thickness of the mask layer corresponds to constructive or destructive interference condition. Due to the non-uniform thickness of the mask layer over the wafer surface the exposure cannot be held constant without additional measures.

In order to obtain a uniform mask exposure it is well known to first deposit an anti-reflective coating layer (ARC layer) to suppress reflections caused at the interface surface between the mask and its underground layer. Especially metal layers having high light reflectance require an ARC layer.

An ARC layer of predetermined optical density and layer thickness decreases the intensity of light repassing the mask layer, thereby reducing standing waves therein. Furthermore, the ARC layer shall planarize the respective semiconductor product surface in order to compensate topographical structures constituted by up-areas and down-areas.

With view to recess filling, an ARC layer consisting of a material of high viscosity is required. On the other hand, for constant thickness, that is for optimal conformity of the ARC layer a low viscosity is recommendable. However, if the viscosity of the ARC layer is too low the thickness of the coating layer at the border of the up-areas becomes too small to grant for sufficient light absorption.

In order to overcome this problem often ARC layers of increased thickness are applied. However, thicker ARC layers suffer from a loss of dimensional accuracy when etching the ARC layer and the underground layer in sequence.

U.S. 5,871,886 discloses a method with applying a first photoresist layer onto the underground layer, then forming an ARC layer thereupon and finally depositing a second photoresist layer onto the ARC layer. The first photoresist layer serves to planarize the surface to be patterned. As a consequence, no major differences in height between up-areas and down-areas appear when the ARC layer is applied, thereby having constant thickness. However, the loss of dimensional accuracy is enhanced because both the ARC layer and the first photoresist layer must be etched.

It is an objective of the invention to provide for improved ARC layer light absorption without deteriorating dimensional accuracy. In particular it is an objective of the invention to provide an ARC layer structure optimized with regard to viscosity which both fills the recesses and provides for sufficient light absorption at the border of up-areas. Hence a light absorbing structure is required which is planarizing as well as conformal.

With view to the semiconductor product this object is achieved by a second anti-reflective coating layer coating the first anti-reflective coating layer, one of the first and second anti-reflective coating layers being a conformal layer and the other one of the first and second anti-reflective coating layers being a planarizing layer. With view to the method for manufacturing a semiconductor product the object is achieved by coating the first anti-reflective coating layer with a second anti-reflective coating layer wherein one of the first and second anti-reflective coating layers is a conformal layer and the other one of the first and second anti-reflective coating layers is a planarizing layer.

Instead of trying to find a compromise between two contradictory requirements concerning the ARC layer, according to the present invention one ARC layer of low viscosity and one further ARC layer of high viscosity are combined, the one being optimized for planarizing performance, the other being optimized for conformance demands. The ARC layer of higher viscosity is used to fill the recesses above the down-areas whereas the ARC layer of lower viscosity is employed to provide for uniform destructive interference all over the wafer plane. No substantial loss of dimensional accuracy occurs as no additional photoresist layer is required.

The one and only photoresist is deposited onto the second ARC layer in the same manner as according to the prior art.

Preferably both the first and the second ARC layers are separately subjected to respective baking process steps after they have been deposited.

Preferably the conformal ARC layer and the planarizing ARC layer are deposited up to a common thickness of lower than 150 nm.

More preferably the conformal ARC layer is deposited up to a thickness between 30 and 70 nm.

Though the invention can be applied to all kinds of underground layers, it is preferably applied to the active area of a semiconductor product or to metal layers, especially to those constituting the bit lines in a DRAM product.

The present invention is described hereinbelow with reference to the accompanying drawings.
Figure 1 illustrates a schematic cross-sectional view of a prior art semiconductor structure.
Figures 2a and 2b illustrate schematic cross-sectional views of semiconductor products according to two embodiments of the present invention.

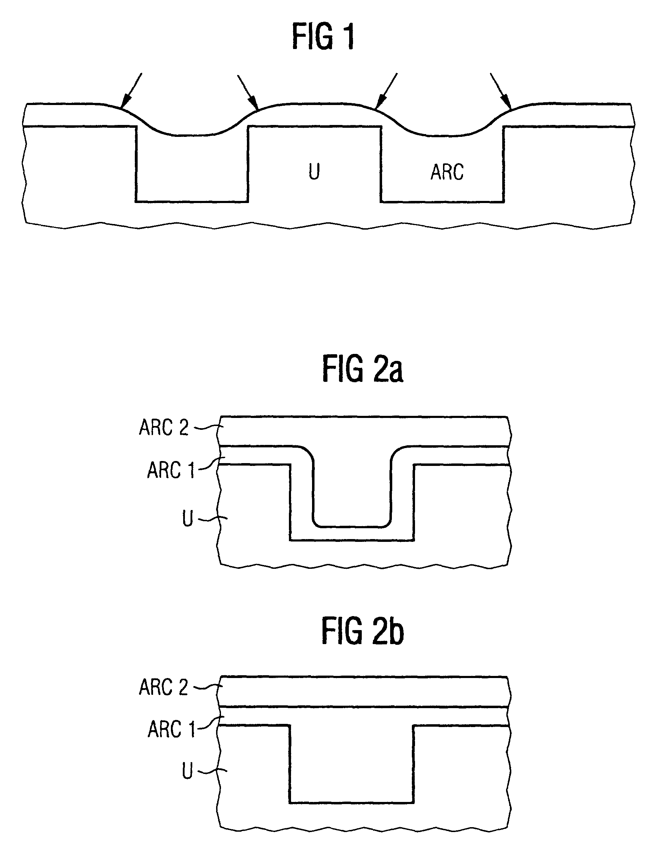

In figure 1 the underground layer U is coated with one single ARC layer of medium viscosity in order to both fill the recesses and allow for sufficient conformity at the same time.

However, at the border of the up-areas the ARC layer thickness is reduced. As a consequence light absorption is deteriorated at the regions indicated by arrows in figure 1.

According to the prior art the thickness of the ARC layer has been enhanced in order to compensate this shortcoming. However, with view to the restricted focal depth of lithographic exposure any increasing in ARC layer thickness deteriorates dimensional accuracy because of lateral etching rates distorting the mask pattern when transferred to the underground layer by removing the ARC layer. Increasing shrink factors of modern semiconductor structures enhance the risk of malfunctions on account of dimensional distortions.

According to figure 2a a first ARC layer ARC1 of low viscosity is deposited onto the underground layer U. The conformity of this layer allows for uniform light absorption all over the wafer surface. In addition, a second ARC layer ARC2 of higher viscosity is deposited thereupon in order to fill the gaps, that is to planarize the semiconductor product.

According to figure 2b the sequence of the conformal and the planarizing ARC layer is reversed. According to this embodiment of the invention no vertical regions of the conformal layer appear as the recess is planarized first.

Though according to the invention two ARC layers are applied thereby constituting an ARC layer structure of increased thickness when compared to a single ARC layer, the total thickness is rather low when comparing typical thickness scales of ARC layers between 30 and 70 nm with typical photoresist layer thickness ranging between 400 and 600 nm.

The present invention is preferably applied to semiconductor wafers with diameters up to 12 inch or 300 mm, as their low rotational speed during ARC spinning requires ARC materials of increasingly low viscosity and hence enhances the risk of insufficient light absorption at the border of up-areas, this problem just being solved by the present invention.

## Claims

1. A semiconductor product comprising:
a) a layer (U) with a surface of high topography, up-areas as well as down-areas being provided on the surface,
b) a first anti-reflective coating layer (ARC1) coating the layer (U),
**characterized by**
c) a second anti-reflective coating layer (ARC2) coating the first anti-reflective coating layer,
one of the first and second anti-reflective coating layers being a conformal layer and the other one of the first and second anti-reflective coating layers being a planarizing layer.

2. The semiconductor product according to claim 1,
**characterized in that** the first anti-reflective coating layer is a conformal layer and the second anti-reflective coating layer is a planarizing layer.

3. The semiconductor product according to claim 1 or 2,
**characterized in that** the conformal anti-reflective coating layer comprises a low viscosity material and the planarizing anti-reflective coating layer comprises a higher viscosity material.

4. The semiconductor product according to one of claims 1 to 3,
**characterized in that** the common thickness of the conformal anti-reflective coating layer and of the planarizing anti-reflective coating layer is lower than 150 nm.

5. The semiconductor product according to one of claims 1 or 4,
**characterized in that** the thickness of the conformal anti-reflective coating layer is between 30 and 70 nm.

6. The semiconductor product according to one of claims 1 to 5,
**characterized in that** the layer is the active area of the semiconductor product.

7. The semiconductor product according to one of claims 1 to 6,
**characterized in that** the layer is a metal layer to be structured to form bit lines of a semiconductor memory.

8. A method for manufacturing a semiconductor product comprising the steps:
a) providing a semiconductor wafer having a layer (U) with a surface of high topography, up-areas as well as down-areas being provided on the surface,
b) coating the layer (U) with a first anti-reflective coating layer (ARC1),
**characterized in that**
c) the first anti-reflective coating layer is coated with a second anti-reflective coating layer (ARC2), wherein one of the first and second anti-reflective coating layers is a conformal layer and the other one of the first and second anti-reflective coating layers is a planarizing layer.

9. The method according to claim 8,
**characterized in that** the first anti-reflective coating layer is a conformal layer and the second anti-reflective coating layer is a planarizing layer.

10. The method according to claim 8 or 9,
**characterized by** depositing a photo resist layer (R) onto the second anti-reflective coating layer.

11. The method according to one of claims 8 to 10,
**characterized by** baking the first anti-reflective coating layer after performing step b) and baking the second anti-reflective coating layer after performing step c).

12. The method according to one of claims 8 to 11,
**characterized in that** the conformal anti-reflective coating layer and the planarizing anti-reflective coating layer are deposited up to a common thickness of lower than 150 nm.

13. The method according to one of claims 8 to 12,
**characterized in that** the conformal anti-reflective coating layer is deposited up to a thickness between 30 and 70 nm.
